# EUROPEAN PATENT APPLICATION

(11) **EP 2 034 516 A1**
(43) Date of publication of application: **11.03.2009**
(21) Application number: 07744121.0
(22) Date of filing: 25.05.2007
(51) Int. Cl.: H01L 21/208, C01B 33/02, H01L 31/04

(54) **METHOD FOR PRODUCING SOLID PHASE SHEET AND SOLAR CELL UTILIZING SOLID PHASE SHEET**

(30) Priority: 16.06.2006 JP 2006167637
(71) Applicant: Sharp Kabushiki Kaisha, Osaka-shi, Osaka 545-8522 (JP)
(72) Inventor: YOSHIDA, Koji, Minamikawachi-gun, Osaka 5830992 (JP)
(74) Representative: Müller - Hoffmann & Partner
(86) International application number: PCT/JP2007/060687
(87) International publication number: WO 2007/145066

(57) **Abstract**

An object of the invention is to solve the problem that a residual melt remaining on a surface of a solid phase sheet (105) of a semiconductor material causes cracks in the solid phase sheet (105), resulting in degraded yield. The residual melt occurs in the process of producing the solid phase sheet (105) on a surface (S11) of the base body (101) by bringing the base body (101) into contact with a melt of semiconductor material. The base body (101) is sectioned by a circumferential groove (102) into a peripheral section and an inner section surrounded by the circumferential groove (102) or has the peripheral section and the inner section partly connected to each other. In the present invention, a slit (103) is provided in the surface of the inner section of the base body (101). The slit (103) is preferably provided at a trailing side in a moving direction in which the surface (S11) of the base body (101) is brought into contact with the melt of semiconductor material. More preferably, a plurality of slits (103) are provided extending from the circumferential groove (102) into the inner section in the moving direction in which the base body (101) is brought into contact with the melt of semiconductor material.

## Description

### TECHNICAL FIELD

The present invention relates to a method for producing a solid phase sheet by deposition of a semiconductor melt on a surface of a base body, and a photovoltaic cell employing the solid phase sheet.

### BACKGROUND ART

A typical method for producing a solid phase sheet such as a polycrystalline silicon wafer employed for a photovoltaic cell includes the steps of forming an ingot made of a semiconductor material and slicing the ingot thin. However, slicing requires a highly advanced technique such that the semiconductor material will not be lost more than the amount corresponding to the thickness of a cutting wire or a circular blade used in slicing.

Instead, a method for producing a solid phase sheet as described in Patent Document 1 (Japanese Patent Laying-Open No. 2002-237465) can be employed. The method for producing a solid phase sheet as described in Patent Document 1 is performed by the following steps. First, base bodies each having a surface sectioned by a circumferential groove into a peripheral section and an inner section surrounded by the circumferential groove are dipped consecutively at regular intervals in an inert atmosphere into a crucible in which a semiconductor material having been heated and melted is stored. The semiconductor material is a high-purity silicon material doped with a dopant such as phosphorus or boron. A solid phase sheet made of the semiconductor material is formed on the surface of the inner section of a base body. The formed solid phase sheet is then separated from the base body and cut into desired dimensions by a laser, dicer or the like according to applications to provide a product such as a wafer for photovoltaic cell.

The above-mentioned method for producing a solid phase sheet employing a base body allows efficient production of a flat solid phase sheet with high dimensional accuracy directly from a melt of semiconductor material while reducing material losses. However, this method causes a state with what is called "a residual melt" where a melt
of semiconductor material condenses by surface tension along a trailing end in the moving direction on the solid phase sheet formed in the inner section when the base body is moved and taken out from the melt of semiconductor material in which the base body has been dipped. This residual melt is formed substantially linearly along the trailing end.

The residual melt has a larger heat capacity than and a different rate of solidification from an area of the solid phase sheet surrounding the residual melt. Accordingly, the melt of semiconductor material undergoes solidification expansion at the time of solidification into solid semiconductor, by which its volume is larger in the solid state than in the melted state. When the residual melt starts solidification, the area of the solid phase sheet surrounding the residual melt has already been solidified. Delayed solidification expansion of the residual melt will cause cracks in its surrounding area of the solid phase sheet. It has been pointed out that this disadvantageously causes defects in the solid phase sheet formed in the inner section qualified as a product, surrounded by the peripheral section, resulting in degraded yield and increased product cost.
Patent Document 1: Japanese Patent Laying-Open No. 2002-237465

### DISCLOSURE OF THE INVENTION

### PROBLEMS TO BE SOLVED BY THE INVENTION

In light of the foregoing problems, the present invention provides a method for producing a uniform and defect-free solid phase sheet while preventing cracks from occurring in the solid phase sheet portion that may be caused by the above-mentioned residual melt. The invention also provides a method for producing a solid phase sheet with improved yield. The invention further provides an inexpensive photovoltaic cell employing the solid phase sheet with improved yield.

### MEANS FOR SOLVING THE PROBLEMS

The present invention relates to a method for producing a solid phase sheet of a semiconductor material on a surface of a base body by bringing the base body into contact with a melt of semiconductor material. The surface of the base body is
sectioned by a circumferential groove into a peripheral section and an inner section surrounded by the circumferential groove or has the peripheral section and the inner section partly connected to each other. A slit is provided in a surface of the inner section.

According to the present invention, the slit is preferably provided at a trailing side in a moving direction in which the surface of the base body is brought into contact with the melt of the semiconductor material. It is also preferable that a plurality of slits extend from the circumferential groove into the inner section in the moving direction in which the surface of the base body is brought into contact with the melt of the semiconductor material.

Further, according to the present invention, the slit preferably has a width of not less than 1 mm and not more than 5 mm. The slit preferably has a length of not less than 5 mm and not more than 20 mm. The slit preferably has a depth of not less than 1 mm and not more than the thickness of the base body.

Furthermore, according to the present invention, a portion divided by the slit preferably has a width of not less than 5 mm and not more than 50 mm. The slit preferably has an end with a curvature, the end being opposite to a side that crosses the circumferential groove.

A method for producing according to the present invention relates to a method for producing a solid phase sheet employing, as a product, a solid phase sheet from which a region provided with the slit has been cut away.

A photovoltaic cell according to the present invention relates to a photovoltaic cell employing, as a product, the solid phase sheet formed by the method for producing the solid phase sheet.

### EFFECTS OF THE INVENTION

The present invention can provide a method by which a flat and uniform solid phase sheet may be produced directly from a melt of semiconductor material with improved yield while reducing losses of the semiconductor material.

### BRIEF DESCRIPTION OF THE DRAWINGS

Fig. 1 is a perspective view showing an embodiment of a base body according to the present invention provided with slits in an inner section surrounded by a circumferential groove.
Fig. 2 is a schematic perspective view showing an embodiment in which the base body according to the present invention provided with slits in an inner section surrounded by a circumferential groove is dipped into a melt of semiconductor material for forming a solid phase sheet.
Fig. 3 is an enlarged cross sectional view showing an embodiment of a base body according to the present invention provided with slits in an inner section surrounded by a circumferential groove.
Fig. 4 is a plan view showing an embodiment of a base body according to the present invention provided with slits in an inner section surrounded by a circumferential groove.
Fig. 5 is a schematic cross sectional view showing an example in a method for producing a solid phase sheet according to the present invention.
Fig. 6 is a perspective view showing an embodiment of a base body according to the present invention provided with slits in an inner section surrounded by a circumferential groove.

### DESCRIPTION OF THE REFERENCE SIGNS

101, 201, 301, 401, 505, 601 base body; 102, 403, 602 circumferential groove; 103, 207, 302, 402, 603 slit; 104, 206 residual melt; 202 dipping mechanism arm section; 203 melt; 204, 501 crucible; 105, 205, 303, 507 solid phase sheet; 404, 604 slit end; 502 chamber; 503 silicon-melting heater; 504 dipping mechanism; 506 silicon melt; 508 transportation conveyor; 509 device subsidiary chamber; 510 gate valve; S11 surface; S21 direction of arrow; S61 inner section

### BEST MODES FOR CARRYING OUT THE INVENTION

### <Basic Structure of Base Body>

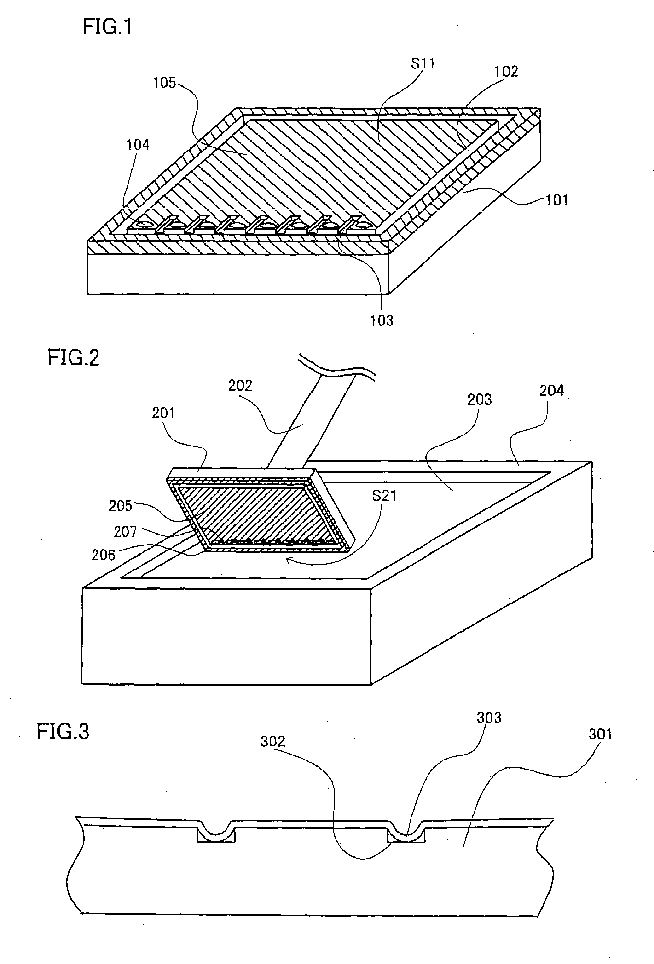

A method for producing a solid phase sheet according to the present invention employs an improved base body to be employed in a method for producing a solid phase sheet by bringing the base body into contact with a melt of semiconductor material to cause uniform deposition of the semiconductor material on the surface of the base body. Means used for bringing the base body into contact with the melt of semiconductor material may take the form of bringing the base body into contact with the melt of semiconductor material in a crucible, or moving the crucible storing the melt of semiconductor material with the base body fixed. The base body employed is one having a surface sectioned by a circumferential groove into a peripheral section and an inner section surrounded by the circumferential groove as mentioned above, or one having the peripheral section and the inner section partly connected to each other. In the case of producing a solid phase sheet in an embodiment shown in Fig. 2 as will be described later, the solid phase sheet will be formed on the back side of the base body. In this case, it is preferable to employ the one having the peripheral section and the inner section partly connected to each other in order for preventing the solid phase sheet from falling down. A base body employed is provided with slits in the surface of the inner section. It is particularly preferable to provide a plurality of such slits extending linearly in a direction perpendicular to the circumferential groove. However, any slits that make an angle of 45 to 90° with respect to the circumferential groove may be employed without any problem. The slits may be corrugated, for example, instead of being linear. Preferably, slits are formed at one side corresponding to the trailing side in the moving direction in which the base body is brought into contact with a melt of semiconductor material. The moving speed when the base body is brought into contact with the melt of semiconductor material is preferably 300 to 1000 cm/min. Although the material for the base body itself is not particularly limited, one having a high heat resistance is preferable considering that the melt of semiconductor material is 1420 to 1500°C. A material of good thermal conductivity is also preferable. High-purity graphite is more preferable in terms of ease of processing. In terms of preventing adhesion and cohesion of a semiconductor material to and on the surface of the base body to reduce the residual melt, graphite is preferably employed as the material for the base body. In addition, the base body may also be made of, for example, silicon carbide, quartz, boron nitride, alumina, and zirconium oxide.

Specific description will be made below based on Fig. 1 showing an embodiment of a base body provided with slits in an inner section surrounded by a circumferential groove. A base body 101 from which a solid phase sheet 105 is to be produced is
characterized in that slits 103 are formed in the inner section of a surface S11 of base body 101 divided by a circumferential groove 102. When base body 101 is brought into contact with a melt of semiconductor material, a state with a residual melt 104 occurs where the melt of semiconductor material condenses by surface tension at a trailing side in the moving direction of the solid phase sheet formed in the inner section. By providing slits 103 in the inner section of base body 101, solid phase sheet 105 (hatched portion) formed in the inner section of base body 101 is divided by slits 103 in a region to be located at the trailing side in the moving direction of base body 101, so that the residual melt is separated.

Herein, residual melt 104 has reduced volume as compared to a residual melt caused by a conventional production method. Residual melt 104 has a larger heat capacitance as compared to its surrounding area and a lower cooling speed as compared to an area free from residual melt 104. A possible consideration is that cracks are more likely to occur in produced solid state sheet 105 due to this difference in cooling speed. However, slits 103 partly dividing solid state sheet 105 have not only the effect of separating residual melt 104 but also the effect of relieving stress towards the solid state sheet due to solidification expansion of residual melt 104. This can prevent cracks from extending into the inner section, and allows a defect-free solid phase sheet of 200 to 400 µm thick to be provided as a product.

A melt of semiconductor material generally has a high viscosity, and hence a higher surface tension as compared to water or the like. It is therefore preferable for separating the residual melt to set conditions for the width, length and depth of each slit as well as the width of a portion divided by slits. The condition setting will be described below in detail.

### <Width of Slit>

The above-mentioned slits for separating the residual melt on the solid phase sheet have an appropriate width. If the slits are excessively narrow in width, the solid phase sheet will be deposited in a bridge-like form over the slits due to surface tension of the melt of semiconductor material, which prevents the essential object of separating the residual melt from being achieved. If the slits are excessively large in width, the melt of semiconductor material will enter the slits to be filling in the respective slits upon solidification in the slits. This interferes with heat contraction of the solid phase sheet, which in turn causes cracks in the solid phase sheet portion formed in the inner section of the base body.

Description will be made below based on Fig. 2 schematically showing an embodiment of forming a solid phase sheet with a melt of semiconductor material. A base body 201 is provided on a leading edge of a dipping mechanism arm section 202. By dipping base body 201 in a direction of arrow S21 into a crucible 204 in which a melt 203 of semiconductor material is stored, a solid phase sheet 205 (hatched portion) is formed on the surface of base body 201. Herein, melt 203 of semiconductor material has viscosity. Accordingly, when a slit 207 has a width of less than 1 mm, solid phase sheet 205 may start to be deposited in a manner spanning over slits 207, which prevents the object of dividing the trailing end of solid phase sheet 205 from being achieved. When slit 207 has a width of more than 5 mm, melt 203 of semiconductor material may start to enter slit 207 to fill in slit 207, which prevents the object of dividing the trailing end of solid phase sheet 205 from being achieved. Thus, the result of experiments shows that slit 207 provided in the aforementioned inner section preferably has a width of not less than 1 mm and not more than 5 mm. To divide the trailing end of solid phase sheet 205 stably by slit 207, it is particularly preferable to set the width of the slit in the vicinity of 3 mm which is a median value between 1 mm at which melt 203 of semiconductor material starts to span over slits 207 and 5 mm at which the melt of semiconductor material starts to enter slit 207.

### <Length of Slit>

In Fig. 2, melt 203 of semiconductor material left on the surface of the trailing part of base body 201 when base body 201 is pulled out from melt 203 of semiconductor material condenses by surface tension, so that a residual melt 206 is formed at the trailing part of divided solid phase sheet 205. Slit 207 provided in the inner section of base body 201 sectioned by the circumferential groove needs to have a length longer than an average diameter of residual melt 206 on the solid phase sheet on the inner section of base body 201. Herein, as to determination of the size of residual melt 206, it is known that a circular residual melt has a diameter of at least 5 mm and about 20 mm at most, many ranging from approximately 7 to 8 mm, depending on the surface tension of the melt of semiconductor material. This shows that slit 207 provided in base body 201 needs to have a length of at least 5 mm or more. According to the result of experiments, the largest diameter of residual melt 206 never exceeds 20 mm. Herein, the region of the solid phase sheet provided with the slits will be removed to produce a product, as will be described later. Therefore, the longer the length of slit 207 than necessary, the smaller the area of solid phase sheet 205 that can be utilized. Thus, taking the foregoing into account, slit 207 provided in the inner section of base body 201 preferably has a length of not less than 5 mm and not more than 20 mm. In consideration of the effective area of solid phase sheet 205 qualified as a product and the dimensions of residual melt 206, a length of about 10 mm is particularly preferable.

### <Depth of Slit>

Specific description will now be made based on Fig. 3 showing an enlarged cross sectional view of slits provided in the inner section of the base body. If a slit 302 provided in the inner section of a base body 301 has a depth of less than 1 mm, a melt of semiconductor material in slit 302 will contact the bottom of slit 302, where a solid phase sheet 303 is deposited. The deposition of solid phase sheet 303 within slit 302 prevents the object of dividing solid phase sheet 303 on the inner section of base body 301 by slit 302 from being achieved. Thus, the stress caused by the residual melt formed between slits 302 in the inner section of base body 301 cannot be relieved, so that solid phase sheet 303 is more likely to be damaged, resulting in degraded yield. Therefore, slit 302 provided in the inner section of the base body sectioned by the circumferential groove preferably has a depth of not less than 1 mm such that the melt of semiconductor material will not be deposited within slit 302. Further, slit 302 cutting through base body 301 presents no particular problem in production of a solid phase sheet. It is therefore preferable to set the depth of slit 302 at not less than 1 mm and not more than the thickness of base body 301. Although slit 302 having a depth of not less than 1 mm can separate the melt of semiconductor material, a depth of not less than 3 mm is particularly preferable for slit 302 because the depth of not less than 3 mm enables reliable separation.

### <Width of portion divided by slits>

Description will be made below based on Fig. 1. The width of each portion divided by slits 103 located at the inner section of base body 101 is also relevant to the size of residual melt 104 that will remain thereat. Since residual melt 104 formed measures at least 5 mm and about 20 mm at most as previously mentioned, each portion divided by slits 103 needs to have a width of at least 5 mm or more. The result of experiments shows that, when the width of each portion divided by slits 103 exceeds 50 mm, cracks are more likely to occur in an area of solid phase sheet 105 surrounding the residual melt due to heat contraction of the residual melt. That is, the effect of division by slits 103 is reduced when the width of each portion divided by slits 103 exceeds 50 mm, so that the influence of stress due to the different rate of solidification of residual melt 104 spreads across solid phase sheet 105, resulting in defects such as breakage and degraded product yield. Therefore, the portion divided by slits 103 preferably has a width of not less than 5 mm and not more than 50 mm. Considering that the size of residual melt 104 mostly ranges from about 7 to 8 mm as mentioned earlier, and that the influence of stress should be minimized, it is particularly preferable that the portion divided by slits 103 provided in the inner section of base body 101 have a width of about 10 mm.

### <Shape of slit end>

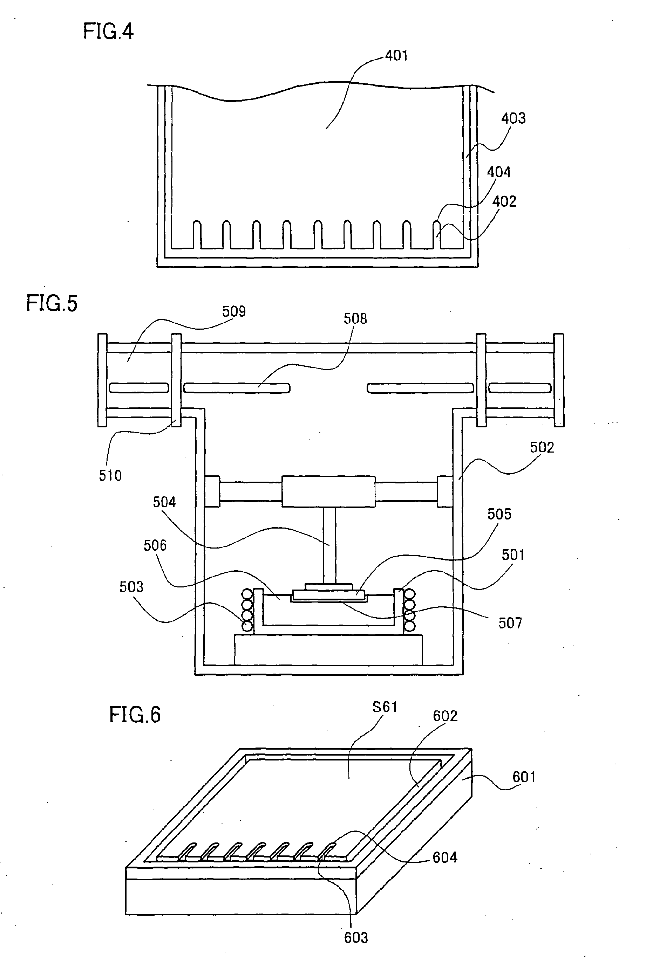

Description will now be made based on Fig. 4 showing a top view of a base body. A residual melt will be formed at a portion divided by slits 402 provided in a base body 401. The different rate of solidification when this residual melt solidifies causes stress to be concentrated on each slit end 404 opposite to the side that crosses a circumferential groove 403 of base body 401, from which cracks are likely to extend into the solid phase sheet. At this stage, if slit end 404 has a corner, stress concentrates further on that part, making the solid phase sheet more likely to break down. Accordingly, providing slit end 404 with a curvature can avoid stress concentration on one point, leading to improved product yield. The smaller the curvature at this stage, the more smooth the transition from the linear segment to the curved segment. A curvature of 1/2 the width of slit 402 is particularly preferable since the stress is minimized when the curvature is a semicircle. That curvature is also particularly preferable in terms of processing.

### <Product (solid phase sheet) and photovoltaic cell>

The solid phase sheet produced by the above-described method of the present invention can be employed as a wafer for photovoltaic cell as it is uniform without defects such as cracks. The method for producing a photovoltaic cell in this case includes forming a doped layer, an anti-reflective coating, a photoreceiving electrode, a rear face electrode, and the like by a well-known method for producing a photovoltaic cell, as well as cutting a solid phase sheet into desired dimensions for use as a wafer for photovoltaic cell. The photovoltaic cell of the present invention can provide increased production yield as compared to a photovoltaic cell produced employing a solid phase sheet produced from a conventional base body.

Herein, in the case of producing a product, in particular a photovoltaic cell, from a solid phase sheet having a region provided with slits (hereinafter also referred to as a slit region) on the solid phase sheet, it is preferable to cut off and remove the slit region. The reason will be described below based on the case of employing the solid phase sheet for a wafer for photovoltaic cell as an example.

Bringing a base body into contact with a melt of high-purity silicon material doped with a dopant such as phosphorus or boron forms a residual melt in the slit region where the wafer for photovoltaic cell is divided by slits provided in the inner section of the base body. Since the residual melt is in the state where the melt of semiconductor material condenses by surface tension to project from its surrounding planar area, there exist residual stress and defective shape. This causes a problem such as damages in the process of producing a photovoltaic cell. Accordingly, in order to use the solid phase sheet including the slit region as a product, specialized processing needs to be performed according to residual melt, leading to increased cost. Further, considering the conversion efficiency in a module as an assembly of wafers for photovoltaic cells employing the slit region as a photoreceiving face, it is assumed that the conversion efficiency is reduced and that the number of wafers for photovoltaic cells necessary for obtaining rated outputs increases. In this case, a photovoltaic cell unnecessarily increases in weight and size, resulting in increased cost in total. Accordingly, cutting off the slit region to produce a product can avoid the above problems. Further, the slit region of the solid phase sheet that cannot be used in a product can be reutilized by remelting after being cut off and removed, which in turn provides improved yield.

In the following, the present invention will be described in more detail illustrating examples, however, the present invention is not limited to these examples.

### EXAMPLE

Description will be made referring to Fig. 5 showing a method for producing a solid phase sheet employed in an embodiment of the present invention. A silicon raw material with the boron concentration adjusted such that a solid phase sheet to be obtained had a specific resistance of 2 Ω•cm was fed into a crucible 501 made of high-purity graphite, which was placed in a chamber 502. Chamber 502 was then evacuated. Thereafter, an argon gas was introduced, and was kept introduced from above chamber 502 always at 100 L/min while maintaining 800 hPa.

A thermoelectric couple for controlling a silicon-melting heater 503 located around crucible 501 was set at a set temperature of 1500°C, to bring silicon into a completely melted state to obtain a silicon melt 506. Since silicon fed initially decreased in volume by melting, silicon was supplied additionally, to thereby bring the surface of silicon melt 506 at a predetermined level. The control temperature was then set at 1430°C and was kept for 30 minutes to stabilize the temperature of silicon melt 506. A base body 505 made of high-purity graphite on which a solid phase sheet was to be formed was then set at the leading edge of a dipping mechanism 504.

Base body 505 was dipped into silicon melt 506 at a speed of 500 cm/min to cause deposition of a solid phase sheet 507 on the surface of base body 505. Base body 505 with solid phase sheet 507 formed thereon was then transferred to a device subsidiary chamber 509 by a transportation conveyor 508, and a gate valve 510 partitioning device subsidiary chamber 509 and chamber 502 body was closed. Then, device subsidiary chamber 509 was evacuated by a rotary pump. After the atmosphere was let in, base body 505 with solid phase sheet 507 formed thereon was taken out of device subsidiary chamber 509. Solid phase sheet 507 formed on base body 505 could easily be detached. Solid phase sheet 507 obtained from the inner section surrounded by the circumferential groove was then cut into dimensions of 126 mm x 126 mm by means of a laser cutting apparatus.

Herein, a base body of similar form to that shown in Fig. 6 representing the base body employed in the present example was employed. The base body was a square measuring 150 mm per side, and base body 601 had a thickness of 20 mm. Slits 603 were provided at the one side that will be taken out lastly from silicon melt 506 in a region sectioned in an inner section S61 surrounded by a circumferential groove 602. At this time, slit 603 had a width of 3 mm, a length of 10 mm and a depth of 3 mm. A portion divided by slits 603 had a width of 10 mm. A slit end 604 of slit 603 opposite to the side that crosses circumferential groove 602 had a curvature of semicircle having a radius of 1.5 mm.

Under the above-described conditions, 1000 solid phase sheets were produced. A load of 50 N/mm² was applied by a bend tester to the laser-cut solid phase sheets to identify the yield. A favorable result of 85.1% was obtained.

Then, a photovoltaic cell was produced employing a solid phase sheet with dimensions of 126 mm x 126 mm obtained by laser cutting, as a wafer for photovoltaic cell. A wafer for photovoltaic cell of the present example will be described below as a p-type substrate. First, the obtained p-type substrate was etched with a mixed solution of nitric acid and hydrofluoric acid, and then subjected to alkaline etching with sodium hydroxide. Thereafter, an n layer was formed on the p-type substrate by POCl₃ diffusion. After removing a PSG (Phospho Silicate Glass) film formed on the surface of the p-type substrate that will be the photoreceiving face side with hydrofluoric acid, a silicon nitride film was formed on the n layer at the photoreceiving face side of the photovoltaic cell by plasma CVD (chemical vapor deposition). An n layer formed on the surface of the photovoltaic cell at the rear face side was then removed by etching with a mixed solution of nitric acid and hydrofluoric acid to uncover the p-type substrate, on which aluminum paste was printed by a screen printing technique and burnt, so that the rear face electrode and a p+ layer were formed at the same time. A solder coating was then applied, to complete the photovoltaic cell.

Cell properties of 100 photovoltaic cells produced by the above-described method were measured under irradiation of AM 1.5 (100 mW/cm²) to obtain favorable results of: an average open-circuit voltage of 580 mV; a short-circuit current of 30.8 mA/cm²; an average fill factor of 0.736; and an average conversion efficiency of 13.1%.

It should be construed that embodiments and examples disclosed herein are by way of illustration in all respects, not by way of limitation. It is intended that the scope of the present invention is defined by claims, not by the description above, and includes all modifications equivalent in meaning and scope to the claims.

### INDUSTRIAL APPLICABILITY

Providing a method for producing a uniform and defect-free solid phase sheet without causing cracks can provide improved yield, resulting in effective utilization of resources. Further, employing the solid phase sheet as a wafer for photovoltaic cell can provide a high-performance photovoltaic cell.

## Claims

1. A method for producing a solid phase sheet (105) of a semiconductor material on a surface (S11) of a base body (101) by bringing said base body (101) into contact with a melt of said semiconductor material, said surface (S11) of said base body (101) being sectioned by a circumferential groove (102) into a peripheral section and an inner section surrounded by said circumferential groove (102) or having said peripheral section and said inner section partly connected to each other, wherein a slit (103) is provided in a surface of said inner section.

2. The method for producing a solid phase sheet (105) according to claim 1, wherein said slit (103) is provided at a trailing side in a moving direction in which said surface (S11) of said base body (101) is brought into contact with said melt of said semiconductor material.

3. The method for producing a solid phase sheet (105) according to claim 1, wherein said slit (103) includes a plurality of slits extending from said circumferential groove (102) into said inner section in a moving direction in which said surface (S11) of said base body (101) is brought into contact with said melt of said semiconductor material.

4. The method for producing a solid phase sheet (105) according to claim 1, wherein said slit (103) has a width of not less than 1 mm and not more than 5 mm.

5. The method for producing a solid phase sheet (105) according to claim 1, wherein said slit (103) has a length of not less than 5 mm and not more than 20 mm.

6. The method for producing a solid phase sheet (105) according to claim 1, wherein said slit (103) has a depth of not less than 1 mm and not more than a thickness of said base body (101).

7. The method for producing a solid phase sheet (105) according to claim 1, wherein a portion divided by said slit (103) has a width of not less than 5 mm and not more than 50 mm.

8. The method for producing a solid phase sheet (105) according to claim 1, wherein said slit (103) has an end with a curvature, said end being opposite to a side that crosses said circumferential groove (102).

9. A method for producing a solid phase sheet (105) employing, as a product, the solid phase sheet (105) as recited in claim 1 formed on the surface of said inner section from which a region provided with said slit (103) has been cut away.

10. A photovoltaic cell employing the solid phase sheet (105) obtained by the method for producing the solid phase sheet (105) as recited in claim 1.
